# EUROPEAN PATENT APPLICATION

(11) **EP 2 460 907 A1**
(43) Date of publication of application: **06.06.2012**
(21) Application number: 10804394.4
(22) Date of filing: 27.07.2010
(51) Int. Cl.: C23C 14/24

(54) **VAPOR DEPOSITION DEVICE FOR OPTICAL LENSES**

(30) Priority: 30.07.2009 JP 2009177531
(71) Applicant: Hoya Corporation, Tokyo 161-8525 (JP)
(72) Inventor: ADACHI,Makoto, Tokyo 161-8525 (JP); KAWAMATA,Kazuo, Tokyo 161-8525 (JP); IGARASHI,Takashi, Tokyo 161-8525 (JP)
(74) Representative: Betten & Resch
(86) International application number: PCT/JP2010/062584
(87) International publication number: WO 2011/013648

(57) **Abstract**

A vapor deposition apparatus for an optical lens (3) includes a lens holding body (10) including a plurality of lens holes (24) formed to be slightly larger than the optical lens (3). This apparatus also includes a holding means (26) for pressing the outer peripheral surface of the optical lens in each lens hole of the lens holding body. This apparatus moreover includes lens receptacles (27a, 27b) which are provided in portions opposed to the holding means on the inner peripheral surface defining each lens hole, and receive the outer peripheral surface of the optical lens. The number of components required to hold the optical lens (3) can be minimized. A film can be formed on the entire optical surface of the optical lens (3) with little possibility that this optical surface will be scratched. A vapor deposition substance adhering and depositing on the holding means (26) is less likely to peel off and adhere onto the optical surface of the optical lens (3). Fine particles generated upon evaporation of the vapor deposition substance are less likely to enter the portion above the optical lens (3) upon passing through the gap between each lens hole (24) and the optical lens (3), so a failure in vapor deposition hardly occurs.

## Description

### Technical Field

In an optical lens, especially a plastic spectacle lens, the optical properties, durability, abrasion resistance, and other properties of the lens are improved by forming, for example, various films such as a protective film on the optical surface. The protective film is topically formed by a hard coat film and an antireflection film.
However, in recent years, a spectacle lens having a film formed under a hard coat film, and a spectacle lens having a water-repellent film formed on an antireflection film are prevailing as well (see, for example, patent literature 1). The film formed under the hard coat film serves to remove cutting traces on the optical surface so as to improve the optical properties of the lens (mainly its brightness). The water-repellent film formed on the antireflection film serves to enhance the water repellency of the lens.

An antireflection film is formed by alternately stacking a high refractive index material and a low refractive index material on each other. As a method of forming an antireflection film, antireflection film formation which uses vacuum vapor deposition is available. In this method, an optical lens is arranged in a vacuum chamber so as to be opposed to an evaporation source, and a vapor deposition substance is heated and evaporated from the evaporation source in a high vacuum to stack and form an antireflection film on the vapor deposition surface (optical surface) of the optical lens.

In a plastic spectacle lens, antireflection films are generally formed on both its optical surface (convex surface) positioned on the object side and that (concave surface) positioned on the eye side when the user wears the lens. The antireflection film on the convex surface is formed mainly in consideration of the user's ambient conditions. The antireflection film on the concave surface is formed mainly to suppress flickering in the field of sight of the user.

As an apparatus for forming vapor deposition films on the two surfaces of a spectacle lens, a reversal vapor deposition apparatus described in patent literature 2, for example, is well known.

The reversal vapor deposition apparatus described in patent literature includes a disk-shaped jig to hold a lens. A plurality of mounting holes are formed by through holes to accommodate the lens. The lens is supported by an engagement step and pressing ring provided in these mounting holes. The engagement step and the pressing ring are formed to clamp and support the outer peripheral edge of the optical surface of the lens. On the other hand, two rotating shafts are provided to project on the outer peripheral surface of the jig. These rotating shafts are rotatably supported by bearings.

In the reversal vapor deposition apparatus, a vapor deposition substance is heated and evaporated so that it adheres and deposits on one optical surface of the lens, and the jig is rotated through 180° by a rotating mechanism. The vapor deposition substance is headed and evaporated again so that it adheres and deposits on the other optical surface of the lens to form a film on this optical surface.

### Related Art Literature

### Patent Literature

Patent Literature 1: Japanese Patent Laid-Open No. 2008-152085
Patent Literature 2: Japanese Patent Laid-Open No. 58-107484

### Disclosure of Invention

### Problem to be Solved by the Invention

However, the reversal vapor deposition apparatus described in the above-mentioned patent literature 2 poses the following problems. First, because the outer peripheral edge of the optical surface of the lens is clamped by the engagement step and the pressing ring, a film cannot be formed on the entire optical surface. Second, when the engagement step and the pressing ring abut against the optical surface, the optical surface is likely to be scratched.

Furthermore, a failure in vapor deposition may occur due to adhesion of a foreign substance onto the optical surface of the lens. This foreign substance is the vapor deposition substance that adheres and deposits on the engagement step or the pressing ring. That is, the vapor deposition substance adhering and depositing on the engagement portion and pressing ring which clamp the lens may peel off from them and adhere onto the optical surface of the lens due to some kind of external factor. When vapor deposition is done while a foreign substance is thus kept adhering on the engagement step and the pressing ring, a failure in vapor deposition occurs.

The present invention has been made in consideration of the above-mentioned conventional problems, and has as its object to provide a vapor deposition apparatus for an optical lens, which can reliably hold a lens and suppress a failure in vapor deposition due to factors associated with a vapor deposition substance.

### Means of Solution to the Problem

In order to achieve the above-mentioned object, according to the present invention, there is provided a vapor deposition apparatus for an optical lens, comprising a vacuum chamber which accommodates a vapor deposition substance and an optical lens, a rotating body which is disposed on an upper side in the vacuum chamber, and rotated by a driving device, a lens holding body which includes a plurality of lens holes formed to be slightly larger than the optical lens, and is detachably mounted on the rotating body, holding means for pressing an outer peripheral surface of the optical lens in each lens hole of the lens holding body, lens receptacles which are provided in portions opposed to the holding means on an inner peripheral surface defining the each lens hole, and receive the outer peripheral surface of the optical lens, pressed by the holding means, upon pressing of the optical lens thereagainst, and heating means which is disposed on a lower side in the vacuum chamber, and heats and evaporates the vapor deposition substance.

### Effects of the Invention

In the present invention, since the holding means presses and holds the outer peripheral surface of the optical lens against and on the lens receptacles provided in the inner peripheral surface defining each lens hole, the number of components required to hold the optical lens can be minimized. Also, since only the outer peripheral surface of the lens is pressed, the optical surface of the optical lens is less likely to be scratched, thus making it possible to form a film on the entire optical surface. Moreover, a vapor deposition substance that adheres and deposits on the holding means is less likely to peel off and adhere onto the optical surface.

Each lens hole is formed to be slightly larger than the optical lens. Hence, fine particles generated upon evaporation of the vapor deposition substance are less likely to pass the portion above the optical lenses upon passing through the gaps between the lens holes and the corresponding lenses. As a result, the fine particles are less likely to adhere onto the surface of the lens, which is opposite to its vapor deposition surface, thus making it possible to suppress the occurrence of a failure in vapor deposition.

### Brief Description of Drawings

Fig. 1 is a sectional view showing the schematic configuration of a vapor deposition apparatus according to the present invention;
Fig. 2 is a front view of a lens holding body;
Fig. 3 is a partially cutaway side view of the lens holding body;
Fig. 4 is a perspective view of the main part of the lens holding body; and
Fig. 5 is a perspective view of a leaf spring.

### Best Mode for Carrying Out the Invention

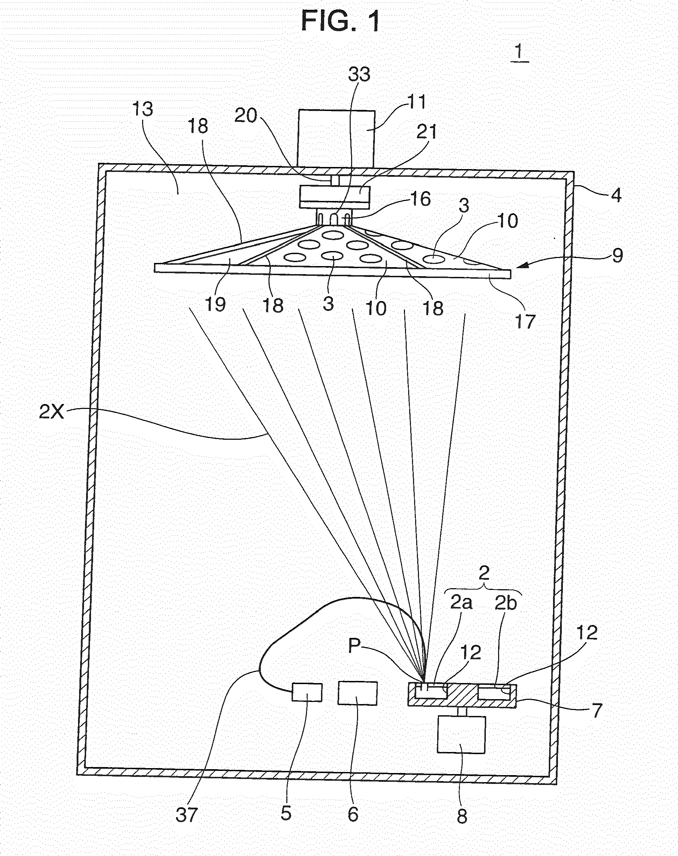

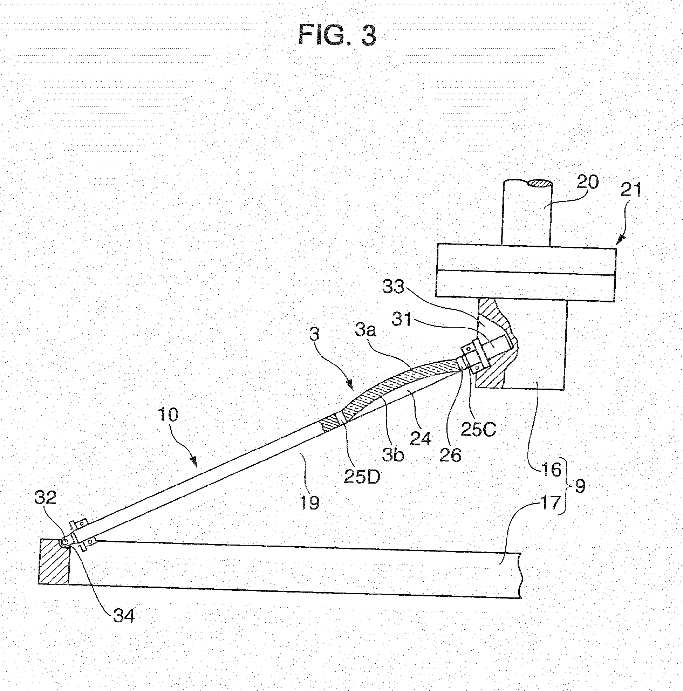

A vapor deposition apparatus according to the present invention will be described in detail below with reference to the accompanying drawings.
Referring to Figs. 1 to 5, a vapor deposition apparatus 1 heats and evaporates a vapor deposition substance 2 to sequentially form films on optical surfaces (vapor deposition surfaces) 3a and 3b of an optical lens 3. The vapor deposition apparatus 1 includes a vacuum chamber 4, and an electron gun (heating means) 5 and magnet 6 disposed on the lower side in the vacuum chamber 4. The vapor deposition apparatus 1 also includes a case 7 which accommodates the vapor deposition substance 2, and a motor 8 which rotates the case 7. The vapor deposition apparatus 1 moreover includes six lens holding bodies 10 (only two lens holding bodies 10 are shown in Fig. 1) disposed together with a rotating body 9 on the upper side in the vacuum chamber 4, and a motor (driving device) 11 provided on the upper surface of the vacuum chamber 4.

A plurality of antireflective materials 2a, 2b,... such as Nb₂O_{5,} ZrO₂, or SiO₂ are used as the vapor deposition substance 2. The vapor deposition substance 2 is accommodated in each accommodation recess 12 of the case 7.

The optical lens 3 is a plastic spectacle lens having a diameter of, for example, 70 mm, and is also a round lens (uncut lens) having both its convex surface 3a and concave surface 3b polished into desired optical surfaces.
Examples of optical blanks for spectacle lenses include a copolymer of methyl methacrylate and one or more types of other monomers, a copolymer of diethyl glycol bisallyl carbonate and one or more types of other monomers, polycarbonate, urethane, polystyrene, polyvinyl chloride, unsaturated polyester, polyethylene terephthalate, polyurethane, polythiourethane, a sulfide formed by an ene-thiol reaction, and a vinyl polymer containing sulfur. Among these optical blanks, a urethane-based optical blank and an allyl-based optical blank are preferable, but the present invention is not limited to these specific optical blanks.

The vacuum chamber 4 is evacuated in vapor deposition by a vacuum pump (not shown) to form a vacuum vapor deposition chamber 13.

The rotating body 9 includes, for example, a rotating shaft 16, a ring 17, and six connecting rods 18. The ring 17 is concentrically arranged under the rotating shaft 16. The connecting rods 18 are arranged equidistantly and radially obliquely downwards around the rotating shaft 16. The lower ends of the connecting rods 18 are fixed on the ring 17. That is, the connecting rods 18 connect the rotating shaft 16 and the ring 17 to each other. Hence, the conical surface-shaped space between the rotating shaft 16 and the ring 17 is divided into spaces 19 having a shape nearly one-sixth of a conical surface shape by the connecting rods 18. The rotating shaft 16 is detachably connected to an output shaft 20 of the motor 11 via a coupling 21.

The lens holding body 10 is formed by a flat plate, having an outer shape which corresponds to an arc one-sixth of a circle when viewed in a plan view, and is similar to and slightly smaller than the space 19 that is formed by the rotating shaft 16 and ring 17 of the rotating body 9 and the connecting rods 18 and has a shape nearly one-sixth of a conical surface shape. Also, the lens holding body 10 includes six lens holes 24 which accommodate optical lenses 3, and four recesses 25A to 25D formed on the peripheral edge defining each lens hole 24. The lens holes 24 are formed on three levels in the radial direction of the lens holding body 10. That is, one lens hole 24 is formed in the portion on the side of a top surface 10a of the lens holding body 10, two lens holes 24 are formed in the middle portions of the lens holding body 10, and three lens holes 24 are formed in the portion on the side of a bottom surface 10b of the lens holding body 10. Also, the lens holes 24 are formed by through holes which open on the front and back surfaces of the lens holding body 10. The lens hole 24 is formed with an inner diameter slightly larger than the outer diameter of the optical lens 3. The lens hole 24 is formed with an inner diameter of, for example, about 71 to 72 mm when the outer diameter of the optical lens 3 is 70 mm.

The four recesses 25A, 25B, 25C, and 25D are formed at angular intervals nearly 90° between them in the circumferential direction of the lens hole 24. The two opposing recesses 25A and 25B among the recesses 25A to 25D are formed with the same, semicircular shape having a size that allows a fingertip to be inserted into them. Also, the recesses 25A and 25B communicate with the lens hole 24, and open on the front and back surfaces of the lens holding body 10. The recess 25C of the remaining two opposing recesses 25C and 25D is formed only in the front surface of the lens holding body 10 along the peripheral edge defining the lens hole 24, and forms a mounting portion for a holding means 26 (to be described later). The recess 25C will also be referred to as the mounting portion 25C hereinafter. Also, the mounting portion 25C is formed to be elongated in the circumferential direction of the lens hole 24. The remaining one recess 25D is formed to open on the front and back surfaces of the lens holding body 10. The recess 25D has two open edges which form lens receptacles 27a and 27b, respectively, that receive an outer peripheral surface 3c of the optical lens 3 and linearly support it. "Linear supporting" means herein that the lens receptacles 27a and 27b support the outer peripheral surface 3c in linear contact with each other. The lens receptacles 27a and 27b are desirably spaced apart from each other by an appropriate distance. The lens receptacles 27a and 27b desirably have a distance of, for example, about 10 to 20 mm between them.

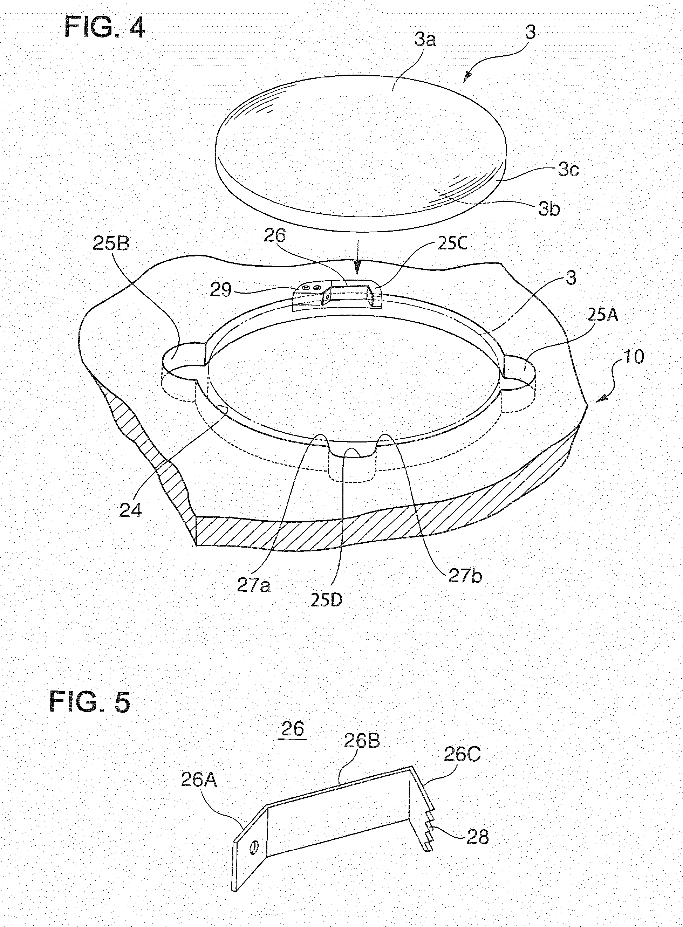

The holding means 26 is formed by a leaf spring. The leaf spring 26 is formed by bending into a predetermined shape, as shown in Fig. 5. The leaf spring 26 integrally includes a fixed proximal portion 26A fixed on a fixing block 29, an elastically deformable portion 26B which is elastically deformable in the thickness direction, and a pressing portion 26C formed at the distal end of the elastically deformable portion 26B by bending inwards at an angle of about 90°. The pressing portion 26C serves to press the outer peripheral surface of the optical lens 3. Serrations 28 are formed at the distal end of the pressing portion 26C to increase the pressing force per unit area, that acts on the optical lens 3. The leaf spring 26 as in this case is fixed onto the mounting portion 25C via the fixing block 29. Upon fixation of the leaf spring 26 onto the mounting portion 25C, the distal end of the pressing portion 26C projects into the lens hole 24 and is directed to the recess 25D in a natural state.

Pivot shafts 31 and 32 project from the centers of the top surface 10a and bottom surface 10b, respectively, of the lens holding body 10. One pivot shaft 31 is removably inserted into a U-shaped shaft hole 33 formed in the outer peripheral surface of the rotating shaft 16, and is rotatably, axially supported in it. In contrast, the other pivot shaft 32 is removably, nonrotatably inserted into a bearing 34 formed on the ring 17.

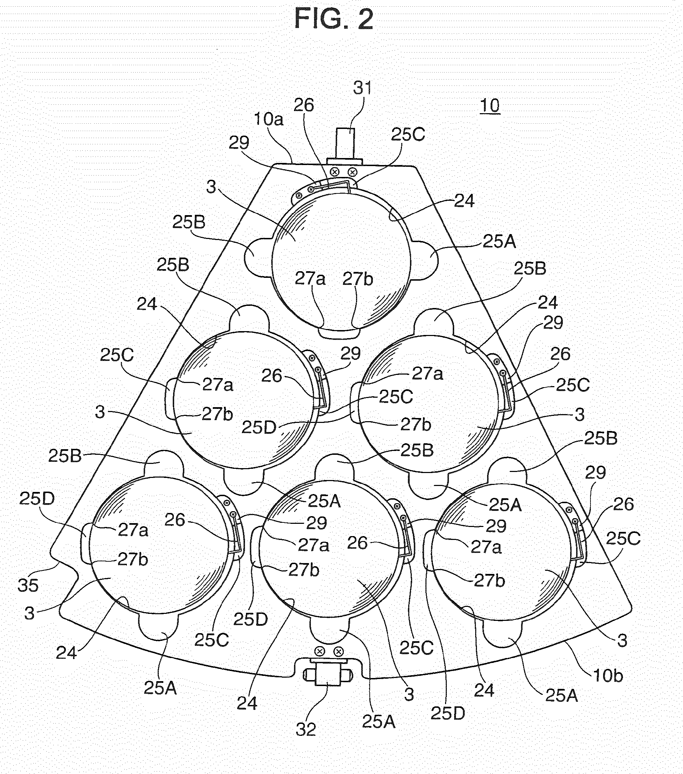

Further, a recess 35 is formed at the bottom corner on the left edge of the lens holding body 10. The lens holding body 10 having the recess 35 formed in it has a bilaterally asymmetrical shape. As a result, the lens holding body 10 is imparted with a property of pivoting clockwise using the pivot shafts 31 and 32 as a center in Fig. 2.

Note that there are four types of uncut optical lenses 3 having outer diameters of, for example, 80 mm, 75 mm, 70 mm, and 65 mm. Hence, four types of lens holding bodies 10 having lens holes 24 with sizes corresponding to these outer diameters are prepared, and a lens holding body having lens holes with a size corresponding to that of lenses used is selected and used.

In the vapor deposition apparatus 1 as described above, the optical lenses 3 are mounted in the lens holes 24 of each lens holding body 10 first in vapor deposition. In mounting the optical lens 3, the elastically deformable portion 26B of the leaf spring 26 is elastically deformed backwards to retract the pressing portion 26C from the lens hole 24 into the mounting portion 25C. One holds the outer peripheral surface of the optical lens 3 between his or her two fingers, and inserts these fingers into the recesses 25A and 25B, thereby inserting the optical lens 3 into the lens hole 24.

The elastically deformable portion 26B of the leaf spring 26 is released. Then, with elastic restoration of the elastically deformable portion 26B, the pressing portion 26C projects into the lens hole 24. Hence, the serrations 28 of the pressing portion 26C press the outer peripheral surface 3c of the optical lens 3 in a point pattern to press the outer peripheral surface 3c on the side opposite to that of the serrations 28 against the lens receptacles 27a and 27b. "Pressing in a point pattern" means herein that the tips of the serrations 28 press the outer peripheral surface 3c in point contact with each other. Therefore, only three portions on the outer peripheral surface 3c of the optical lens 3 are held and fixed in the lens hole 24.

After the optical lenses 3 are mounted in the lens holes 24 of each lens holding body 10, the lens holding body 10 is fitted into each space 19 of the rotating body 9. This is done so that the vapor deposition surfaces 3b of the optical lenses 3 face down. The pivot shaft 31 is inserted into the shaft hole 33 in the rotating shaft 16 so that the pivot shaft 32 engages with the bearing 34 of the ring 17. When all of the six lens holding bodies 10 are mounted on the rotating body 9, they form a six-sided pyramid to cover each space 19 of the rotating body 9.

When the lens holding bodies 10 have been mounted on the rotating body 9, the gaps between the lens holding bodies 10 and the rotating shaft 16, ring 17, and connecting rods 18, and those between the optical lenses 3 and the lens holes 24 are set as narrow as possible. That is, if the gaps between the lens holding bodies 10 and the rotating shaft 16, ring 17, and connecting rods 18, and those between the optical lenses 3 and the lens holes 24 are large, fine particles 2X generated upon evaporation of the vapor deposition substance 2 may enter the portion above the lens holding bodies 10 upon passing through these gaps. When the fine particles 2X having entered the portion above the lens holding bodies 10 in this manner adhere onto the convex surfaces 3a of the optical lenses 3, this leads to a failure in vapor deposition. For this reason, it is desirable to set the above-mentioned gaps as narrow as possible so as to prevent the fine particles 2X generated upon evaporation of the vapor deposition substance 2 from entering the portion above the lens holding bodies 10. Also, to prevent the fine particles 2X generated upon evaporation of the vapor deposition substance 2 from adhering onto the optical lenses 3 due to their entrance to the portion above the lens holding bodies 10, it is desirable to cover the entire upper optical surfaces 3a of the optical lenses 3 with a resin film.

When the operation of mounting the lens holding bodies 10 on the rotating body 9 is complete, the rotating body 9 is inserted into the vacuum chamber 4 to mount the rotating shaft 16 on the output shaft 20 of the motor 11 via the coupling 21.

After the rotating body 9 is mounted on the output shaft 20, the vacuum chamber 4 is evacuated to a predetermined degree of vacuum. The motor 11 is driven to rotate the rotating body 9 at a predetermined speed. Also, the case 7 is pivoted by the motor 8 to move the vapor deposition substance (antireflective material) 2a to be vapor-deposited first to a beam irradiation position P. Also, the electron gun 5 is turned on to emit an electron beam 37, which is deflected by a magnetic field generated by the magnet 6 and is guided to the beam irradiation position P. Upon guidance of the electron beam 37 to the beam irradiation position P, the vapor deposition substance 2a is heated and evaporated. The fine particles 2X generated upon evaporation of the antireflective material 2a adhere and deposit on the concave surfaces 3b of the optical lenses 3, so a lowermost antireflection film is formed with a predetermined thickness.

When vapor deposition of a lowermost antireflection film is complete, the motor 8 is driven to pivot the case 7 through a predetermined angle, thereby moving the vapor deposition substance 2b to the beam irradiation position P so that a second layer is formed. The vapor deposition substance 2b is heated and evaporated by the electron beam 37 to form an antireflection film on the lowermost antireflection film as a second layer. In the same way, antireflection films are vapor-deposited as a third layer, a fourth layer,..., and an uppermost layer to form a multilayered antireflection film.

After the process of vapor-depositing a multilayered antireflection film on the concave surfaces 3b of the optical lenses 3 is completed, a multilayered antireflection film is subsequently vapor-deposited on the convex surfaces 3a of the optical lenses 3. In vapor deposition on the convex surfaces 3a, first, the rotating body 9 is removed from the vacuum chamber 4, and the lens holding bodies 10 are reversed so that the convex surfaces 3a of the optical lenses 3 face down. Next, the rotating body 9 is inserted into the vacuum chamber 4 again to mount it on the output shaft 20 via the coupling 21. The vacuum chamber 4 is evacuated again to a predetermined degree of vacuum, and a multilayered antireflection film is vapor-deposited on the convex surfaces 3a in accordance with the above-mentioned procedure. At this time as well, it is desirable to protect the upper, concave surfaces 3b of the optical lenses 3 with a resin film so as to prevent fine particles generated upon evaporation of the vapor deposition substance from adhering onto the optical lenses 3 due to their entrance to the portion above the lens holding bodies 10. Note that when the process of vapor-depositing an antireflection film on the convex surfaces 3a of the optical lenses 3 is complete, the rotating body 9 is removed from the vacuum chamber 4, the optical lenses 3 are also removed from the lens holes 24 in each lens holding body 10, and optical performance inspection and appearance inspection are conducted for the optical lenses 3.

In this manner, in the vapor deposition apparatus 1 according to the present invention, only three portions on the outer peripheral surface of the optical lens 3 are held by the leaf spring 26 and lens receptacles 27a and 27b, and the optical surfaces 3a and 3b are not held. Hence, the vapor deposition apparatus 1 can vapor-deposit a vapor deposition substance on the entire optical surfaces 3a and 3b with little possibility that it will damage the optical surfaces 3a and 3b. Also, since the serrations 28 are provided to the pressing portion 26C of the leaf spring 26, the optical lens 3 can be pressed with a large pressing force without sliding it. Hence, the optical lenses 3 can be stably held in the lens holes 24 with no possibility that they will fall from the lens holes 24 when the vapor deposition apparatus 1 reverses the lens holding bodies 10.

Also, in the vapor deposition apparatus 1, the gaps between the rotating body 9 and the lens holding bodies 10, and those between the optical lenses 3 and the lens holes 24 are formed as narrow as possible. Hence, fine particles generated upon evaporation of the vapor deposition substance can be prevented from entering the portion above the lens holding bodies 10, and adhering onto the upper optical surfaces. Further, even if the vapor deposition substance adhering and depositing on the leaf spring 26 and lens receptacles 27a and 27b peels off, it is less likely to adhere onto the optical surfaces 3a and 3b of the optical lens 3 as dust. This is because the outer peripheral surface 3c of the optical lens 3 is held. Hence, the vapor deposition apparatus 1 can prevent a failure in vapor deposition, thus improving the productivity.

Note that the above-described embodiment provides an example in which six lens holding bodies 10 having a shape corresponding to an arc one-sixth of a circle are mounted on the rotating body 9. However, the present invention is not particularly limited to this, and one lens holding body having, for example, a conical shape or flat circular shape may be used.

### Explanation of the Reference Numerals and Signs

1... vapor deposition apparatus, 2... vapor deposition substance, 3... optical lens, 4... vacuum chamber, 5... electron gun, 7... case, 9... rotating body, 10... lens holding body, 11... motor, 26... holding means, 27a, 27b... lens receptacles.

## Claims

1. A vapor deposition apparatus for an optical lens, comprising:
a vacuum chamber which accommodates a vapor deposition substance and an optical lens;
a rotating body which is disposed on an upper side in said vacuum chamber, and rotated by a driving device;
a lens holding body which includes a plurality of lens holes formed to be slightly larger than the optical lens, and is detachably mounted on said rotating body;
holding means for pressing an outer peripheral surface of the optical lens in each lens hole of said lens holding body;
lens receptacles which are provided in portions opposed to said holding means on an inner peripheral surface defining the each lens hole, and receive the outer peripheral surface of the optical lens, pressed by said holding means, upon pressing of the optical lens thereagainst; and
heating means which is disposed on a lower side in said vacuum chamber, and heats and evaporates the vapor deposition substance.

2. A vapor deposition apparatus for an optical lens according to claim 1, further comprising a recess formed in a surface of said lens holding body along the each lens hole,
wherein said holding means is disposed in said recess, and formed by a leaf spring which integrally includes a fixed proximal portion, an elastically deformable portion, and a pressing portion that dresses the outer peripheral surface of the optical lens, and
serrations are formed at a distal end of said pressing portion.

3. A vapor deposition apparatus for an optical lens according to claim 1, wherein
said lens holding body includes a recess which is opposed to said holding means and formed along the each lens hole, and
two open edges of said recess form said lens receptacles, respectively, and hold three portions on the outer peripheral surface of the optical lens in cooperation with said holding means.
